# EUROPEAN PATENT APPLICATION

(11) **EP 4 770 301 A1**
(43) Date of publication of application: **01.07.2026**
(21) Application number: 25212314.6
(22) Date of filing: 30.10.2025
(51) Int. Cl.: H05K 9/00

(54) **ELECTRONIC DEVICE**

(30) Priority: 26.12.2024 JP 2024230363
(71) Applicant: Japan Aviation Electronics Industry, Limited, Tokyo 150-0043 (JP)
(72) Inventor: KASAI, Yuki, Tokyo, 150-0043 (JP); IWAO, Naoki, Tokyo, 150-0043 (JP); NAKAMURA, Kazunobu, Tokyo, 150-0043 (JP)
(74) Representative: Prüfer & Partner mbB Patentanwälte · Rechtsanwälte

(57) **Abstract**

An electronic device includes interior components mounted on a mounting board so as to be located in a predetermined region and straddling components mounted on the mounting board so as to straggle a boundary line between inside and outside of the predetermined region. A shield case is mounted on the mounting board so that a sidewall portion is located on the boundary line. The sidewall portion has a half wall portion. The half wall portion does not reach a lower end of the shield case, and an opening portion is formed under the half wall portion so as to connect inside and outside of the shield case. The straddling components are partly located in the opening portion just under the half wall portion. A lower end of the half wall portion is located downward of an upper end of the highest one of the interior components.

## Description

### BACKGROUND OF THE INVENTION

This invention relates to an electronic device, particularly, to an electronic device provided with a shield case.

JP2002-232179A (Patent Document 1) discloses an electronic device having a structure in which a plurality of electronic components mounted on a mounting board is covered by a cap or shield case.

As shown in Fig. 8, an electronic device 80 disclosed in Patent Document 1 is provided with a mounting board 801, a plurality of electronic components 803 mounted on the mounting board 801 and a cap or shield case attached to the mounting board 801 so as to cover the electronic components 803.

### SUMMARY OF THE INVENTION

The cap or shield case 805 of the electronic device 80 disclosed in Patent Document 1 has such a problem that it is easy to increase a size of the electronic device 80.

It is an object of the present invention to provide a shield case which can contribute to miniaturization of an electronic device and to provide an electronic device using the shield case.

One aspect of the present invention provides an electronic device comprising a mounting board, a plurality of elemental devices and a shield case. The mounting board has a predetermined region. Each of the elemental devices is an electric component or an electronic component. The elemental devices include at least one interior component and at least one straddling component. The at least one interior component is mounted on the mounting board so as to be located in the predetermined region. The at least one straddling component is mounted on the mounting board so as to straddle a boundary line between an inside of the predetermined region and an outside of the predetermined region. The shield case has a top surface portion and a sidewall portion extending downward from the top surface portion. The shield case is mounted on the mounting board so that the sidewall portion is located on the boundary line between the inside of the predetermined region and the outside of the predetermined region when the shield case is viewed from above. The sidewall portion has a full wall portion reaching a lower end of the shield case and a half wall portion extending downward from the top surface portion by a predetermined size. The half wall portion does not reach the lower end of the shield case, so that an opening portion is formed under the half wall portion so as to communicate an inside of the shield case with an outside of the shield case. The at least one straddling component is located in the opening portion in part just under the half wall portion. A lower end of the half wall portion is located downward of an upper end of a highest one of the at least one interior component in an up-down direction.

Another aspect of the present invention provides a shield case which is used for covering an elemental device arranged on a predetermined region of a mounting board when the shield case is mounted on the mounting board having the predetermined region. The shield case has a top surface portion and a sidewall portion extending downward from the top surface portion. The shield case is mounted on the mounting board when used so that the sidewall portion is located on a boundary line between an inside of the predetermined region and an outside of the predetermined region when viewed from above. The sidewall portion has a full wall portion reaching a lower end of the shield case and a half wall portion extending downward from the top surface portion by a predetermined size. The half wall portion does not reach the lower end of the shield case, so that an opening portion is formed under the half wall portion so as to communicate an inside of the shield case with an outside of the shield case. The opening portion allows the elemental device to be mounted on the mounting board so that the elemental device straddles the boundary line between the inside of the predetermined region of the mounting board and the outside of the predetermined region of the mounting board.

The shield case according to the aforementioned aspect of the present invention allows the elemental device to be mounted on the mounting board so that the elemental device straddles the boundary line between the inside of the predetermined region of the mounting board and the outside of the predetermined region of the mounting board through the opening portion formed under the half wall portion. With this structure, an elemental device having high relevance to another elemental device which may be a noise source can be arranged near the other elemental device which may be the noise source, and a wiring length therebetween can be shortened. In addition, the shield case can be miniaturized because it is not necessary to cover the elemental devices in a lump with the shield case. In this way, the shield case according to the aforementioned aspect of the present invention allows the wiring length on the mounting board to be shortened and itself to be miniaturized, so that the electronic device can be miniaturized. Moreover, the miniaturization of the electronic device can reduce costs including a cost of materials for the electronic device and a cost of mounting and processing for the electronic device. Furthermore, the shortening of the wiring length on the mounting board can improve efficiency of the electronic device and reduce radiation of electromagnetic noise.

An appreciation of the objectives of the present invention and a more complete understanding of its structure may be had by studying the following description of the preferred embodiment and by referring to the accompanying drawings.

### BRIEF DESCRIPTION OF THE DRAWINGS

Fig. 1 is a perspective view showing an electronic device according to an embodiment of the present invention.
Fig. 2 is a perspective view showing a shield case included in the electronic device of Fig. 1.
Fig. 3 is a plan view showing the electronic device of Fig. 1.
Fig. 4 is a plan view showing a mounting board and elemental devices which are included in the electronic device of Fig. 3. A chain double-dashed line indicates a boundary line of a predetermined region on the mounting board.
Fig. 5 is a plan view showing the electronic device of Fig. 3. Dashed lines indicate inner surfaces of the shield case, the elemental devices covered by the shield case and ground patterns.
Fig. 6 is a cross-sectional view showing the electronic device of Fig. 5, taken along A-A line.
Fig. 7 is a cross-sectional view showing the electronic device of Fig. 5, taken along B-B line.
Fig. 8 is a cross-sectional view showing an electronic device disclosed in Patent Document 1.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims.

### DETAILED DESCRIPTION

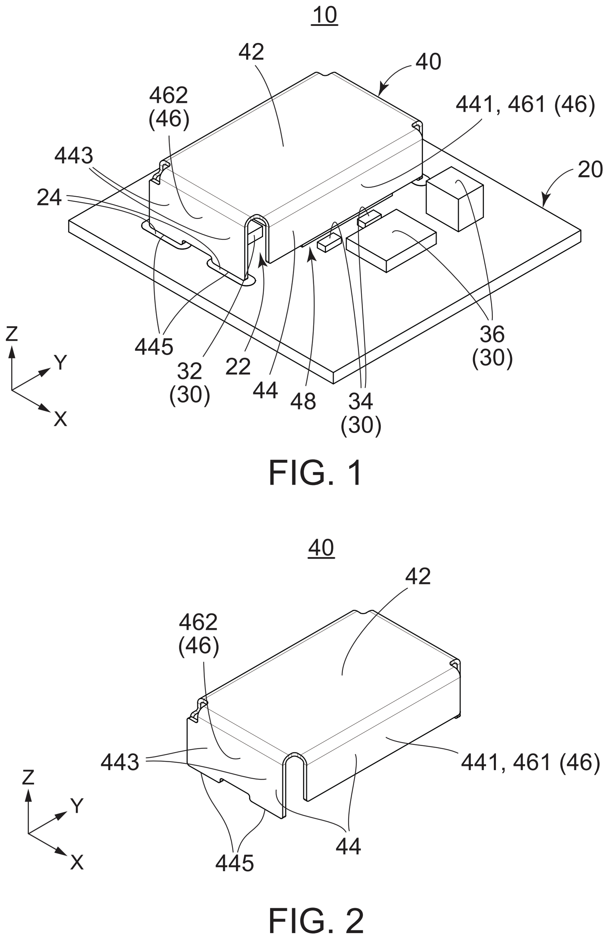

Referring to Fig. 1, an electronic device 10 according to an embodiment of the present invention is provided with a mounting board 20, a plurality of elemental devices 30 and a shield case 40. The elemental devices 30 and the shield case 40 are mounted on an upper surface of the mounting board 20. In the present embodiment, an up-down direction is a Z-direction. A positive Z-direction is directed upward while a negative Z-direction is directed downward.

As shown in Fig. 4, the mounting board 20 has a predetermined region 22 on the upper surface thereof. In the present embodiment, the predetermined region 22 is a region on which the elemental devices 30 to be covered by the shield case 40 are mounted. Furthermore, in the present embodiment, a plurality of ground patterns 24 are formed on a boundary line 221 between the predetermined region 22 and the vicinity of the predetermined region 22. In the present embodiment, the predetermined region 22 is rectangular in shape. However, in the present invention, the shape of the predetermined region 22 is not particularly limited, and it may be another shape, such as a round shape, a polygon or a race-track shape.

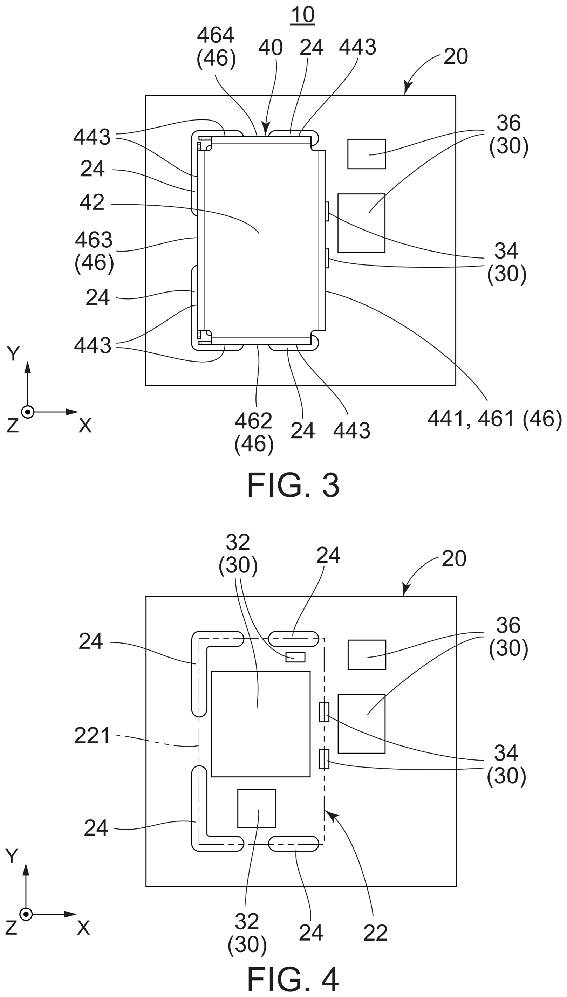

As understood from Figs. 3 and 4, the elemental devices 30 include at least one interior component 32 which is mounted on the mounting board 20 so as to be located in the predetermined region 22. In the present embodiment, the at least one interior component 32 is three in number. Each of the interior components 32 is the elemental device 30 which may be a noise source or the elemental device 30 to be arranged close to the elemental device 30 which may be the noise source. Additionally, in the present embodiment, each of the elemental devices 30 is an electronic component or an electric component. The electric component may be an inductor.

As understood from Figs. 3 and 4, the elemental devices 30 include at least one straddling component 34 which is mounted on the mounting board 20 so as to straddle the boundary line 221 between an inside of the predetermined region 22 and an outside of the predetermined region 22. In the present embodiment, the at least one straddling component 34 is two in number. Each of the straddling components 34 is the elemental device 30 to be arranged close to the elemental device 30 which may be a noise source.

As shown in Fig. 3 or 4, in the present invention, the elemental devices 30 may include at least one exterior component 36 which is mounted on the mounting board 20 so as to be located outside the predetermined region 22. In the present embodiment, the elemental devices 30 include two exterior components 36.

Referring to Fig. 2, the shield case 40 has a top surface portion 42 and a sidewall portion 44 extending downward from the top surface portion 42. The shield case 40 is a component that is mounted on the mounting board 20 (see Fig. 4) having the predetermined region 22 (see Fig. 4) and covers the elemental devices 30 arranged on the predetermined region 22, or the interior components 32 (see Fig. 4). The shield case 40 may be formed by bending a sheet metal, for example. Alternatively, the shield case 40 may be formed by drawing a sheet metal.

As shown in Fig. 2, in the present embodiment, the sidewall portion 44 of the shield case 40 has a generally low profile polygonal tubular shape. In detail, the sidewall portion 44 of the shield case 40 has a rectangular tubular shape. In the present embodiment, the top surface portion 42 has a rectangular shape when viewed from above. However, the present invention is not limited thereto. The shape of the top surface portion 42 may be another shape, such as a round shape, a polygon or a race-track shape, provided that it corresponds to the shape of the predetermined region 22.

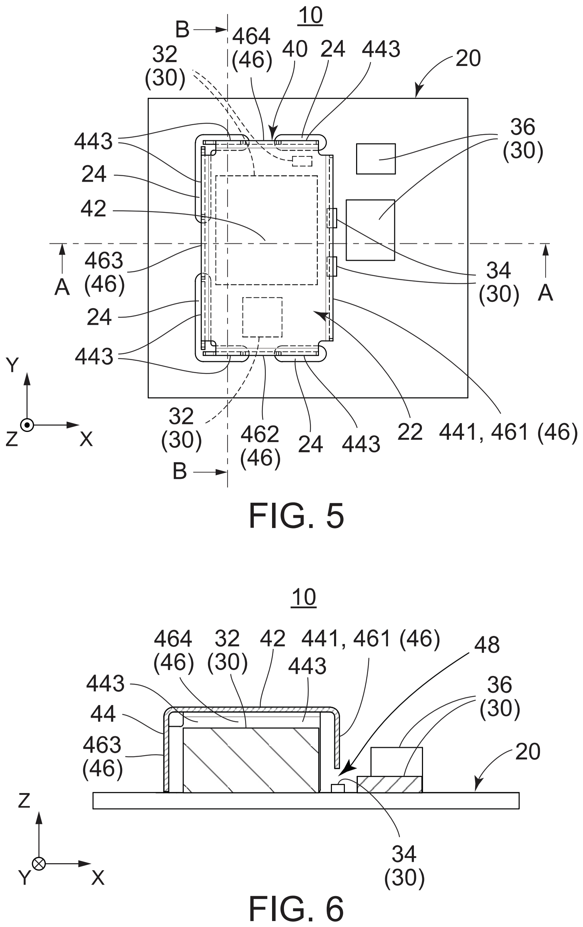

As understood from Figs. 2 and 5, the sidewall portion 44 is provided with a plurality of side surfaces 46 (461-464). In the present embodiment, the side surfaces 46 are four in number. Moreover, in the present embodiment, the side surfaces 46 are separated from one another. However, the present invention is not limited thereto. In the present invention, the number of the side surfaces 46 may be decided based on the shape of the top surface portion 42. For example, the sidewall portion 44 may be provided with a single side surface 46 which is formed in a cylinder shape. Alternatively, the side surfaces 46 may be contiguous to one another to form a polygonal tube.

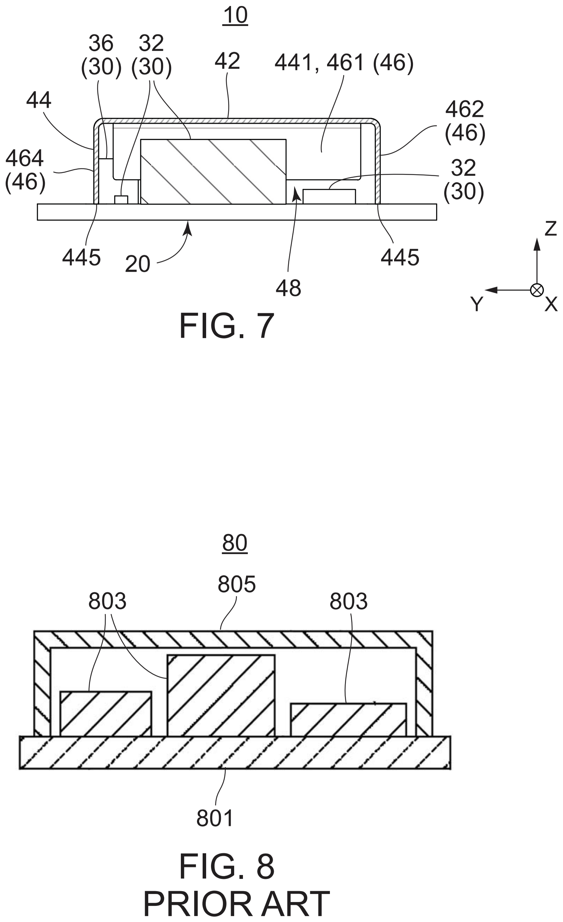

As understood from Figs. 6 and 7, the side surface 461 extends downward from the top surface portion 42 by a predetermined size and forms a half wall portion 441 which does not reach a lower end of the shield case 40. The predetermined size will be described later. Thus, the sidewall portion 44 has the half wall portion 441, and the side surface 461 is a specific side surface 461 having the half wall portion 441. However, the present invention is not limited thereto. The half wall portion 441 may be provided as a part of the side surface 461. At any rate, the side surfaces 46 include the specific side surface 461 having the half wall portion 441.

As understood from Figs. 2, 6 and 7, each of the side surfaces 462, 463 and 464 has a portion, or a full wall portion 443, which extends downward from the top surface portion 42 and reaches the lower end of the shield case 40. Thus, the sidewall portion 44 has the full wall portions 443, and each of the side surfaces 462, 463 and 464 is a normal side surface 462, 463 or 464 which does not have the half wall portion 441. However, the present invention is not limited thereto. Each of the side surfaces 462, 463 and 464 may form the full wall portion 443 as a whole. At any rate, the side surfaces 46 include the normal side surfaces 462, 463 and 464 other than the specific side surface 461.

As understood from Figs. 6 and 7, an opening portion 48 is formed under the specific side surface 461 so as to communicate an inside of the shield case 40 with an outside of the shield case 40. When the half wall portion 441 is formed in a part of the side surface 461, the opening portion 48 is formed just under the half wall portion 441. At any rate, the opening portion 48 is formed in the specific side surface 461.

As understood from Figs. 4 and 5, the mounting of the shield case 40 on the mounting board 20 is carried out so that the sidewall portion 44 is located on the boundary line 221 between the inside of the predetermined region 22 and the outside of the predetermined region 22 when the shield case 40 is viewed from above. The straddling component 34 is mounted on the mounting board 20 so as to be located, in part, on the boundary line 221 between the inside of the predetermined region 22 and the outside of the predetermined region 22. When the shield case 40 is mounted on the mounting board 20, it follows that the straddling component 34 is mounted on the mounting board 20 so as to pass through the opening portion 48 just under the half wall portion 441 and to be located from the inside of the opening portion 48 to the outside of the opening portion 48. In other words, the opening portion 48 allows the elemental devices 30 to be mounted on the mounting board 20 and to straddle the boundary line 221 between the inside of the predetermined region 22 of the mounting board 20 and the outside of the predetermined region 22 of the mounting board 20. Although, in the present embodiment, the straddling component 34 protrudes from the opening portion 48 on both sides in a thickness direction of the half wall portion 441, the present invention is not limited thereto. In the present invention, the straddling component 34 may protrude from the opening portion 48 on only one side in the thickness direction of the half wall portion 441. At any rate, the straddling component 34 should be partly located in the opening portion 48 just under the half wall portion 441.

As understood from Figs. 1 and 2, the shield case 40 has connection portions 445 which are connected to the ground patterns 24 on the mounting board 20. In detail, each of the normal side surfaces 462, 463 and 464 has a pair of connection portions 445. The pairs of connection portions 445 correspond to the full wall portions 443, respectively. In a horizontal direction perpendicular to the up-down direction, the connection portions 445 of each pair are located at both end portions of each of the side surfaces 462, 463 and 464. In the present embodiment, the horizontal direction is an X-direction or a Y-direction and is a longitudinal direction of each of the side surfaces 462, 463 and 464. In detail, for the side surfaces 462 and 464, the horizontal direction is the X-direction, and for the side surface 463, the horizontal direction is the Y-direction.

As understood from Figs. 1 and 2, in the present embodiment, a total length of the connection portions 445 in the horizontal direction is shorter than a total length of the normal side surfaces 462, 463 and 464 in the horizontal direction. This is for reducing stress caused by temperature variation in solder (not shown) which connects the connection portions 445 to the ground patterns 24 as far as possible. It is preferable that the total length of the connection portions 445 is shorter, provided that it has a desirable connection strength and it does not deteriorate electromagnetic noise shield effect of the shield case 40.

As understood from Figs. 6 and 7, a lower end of the specific side surface 461 or the half wall portion 441 is located downward of an upper end of the highest one of the interior components 32 in the up-down direction. The lower end of the half wall portion 441 is located upward of the highest one of the straddling components 34 in the up-down direction. The predetermined size of the half wall portion 441 is decided based on the heights of the interior components 32 and the heights of the straddling components 34. With this structure, the shield case 40 can achieve electromagnetic noise shield effect equal to that in a case where the interior components 32 are completely covered thereby. However, it is preferable that the lower end of the specific side surface 461 or the half wall portion 441 is located downward of the upper end of the interior component 32 which may be a noise source when the interior components 32 include one higher than the interior component 32 which may be a noise source.

As mentioned above, in the electronic device 10 according to the present embodiment, the shield case 40 has the opening portion 48. Accordingly, the elemental devices 30 can be mounted on the mounting board 20 so as to straddle the boundary line 221 between the inside of the predetermined region 22 of the mounting board 20 and the outside of the predetermined region 22 of the mounting board 20. In other words, the electronic device 10 according to the present embodiment has an increased degree of design freedom for the mounting board 20. With this structure, distances between the elemental devices 30 and a wiring length on the mounting board 20 can be shortened, so that not only the shield case 40 but also the electronic device 10 can be miniaturized. Moreover, in accordance with the miniaturization of the electronic device 10, costs including a cost of materials and a cost of mounting and processing can be reduced. Furthermore, by shortening the wiring length on the mounting board 20, efficiency of the electronic device 10 can be improved and radiation of electromagnetic noise from the electronic device 10 can be reduced.

Although the specific explanation about the present invention is made above with reference to concrete embodiments, the present invention is not limited thereto but susceptible of various modifications and alternative forms without departing from the spirit of the invention. For example, although the number of the half wall portion 441 is equal to one in the aforementioned embodiment, two or more half wall portions 441 may be provided. The half wall portions 441 may be provided to one of the side surfaces 46 or to the side surfaces 46, respectively. Nevertheless, the structure in which a single half wall portion 441 is formed in one of the side surfaces 46 as the aforementioned embodiment is simple, and the manufacture of the shield case 40 is easy.

While there has been described what is believed to be the preferred embodiment of the invention, those skilled in the art will recognize that other and further modifications may be made thereto without departing from the spirit of the invention, and it is intended to claim all such embodiments that fall within the true scope of the invention.

## Claims

1. An electronic device comprising a mounting board, a plurality of elemental devices and a shield case, wherein:
the mounting board has a predetermined region;
each of the elemental devices is an electric component or an electronic component;
the elemental devices include at least one interior component and at least one straddling component;
the at least one interior component is mounted on the mounting board so as to be located in the predetermined region;
the at least one straddling component is mounted on the mounting board so as to straddle a boundary line between an inside of the predetermined region and an outside of the predetermined region;
the shield case has a top surface portion and a sidewall portion extending downward from the top surface portion;
the shield case is mounted on the mounting board so that the sidewall portion is located on the boundary line between the inside of the predetermined region and the outside of the predetermined region when the shield case is viewed from above;
the sidewall portion has a full wall portion reaching a lower end of the shield case and a half wall portion extending downward from the top surface portion by a predetermined size;
the half wall portion does not reach the lower end of the shield case, so that an opening portion is formed under the half wall portion so as to communicate an inside of the shield case with an outside of the shield case;
the at least one straddling component is located in the opening portion in part just under the half wall portion; and
a lower end of the half wall portion is located downward of an upper end of a highest one of the at least one interior component in an up-down direction.

2. The electronic device as recited in claim 1, wherein:
the sidewall portion of the shield case has a polygonal tubular shape and comprises a plurality of side surfaces;
the side surfaces include a specific side surface having the half wall portion and a plurality of normal side surfaces other than the specific side surface;
the specific side surface is provided with the opening portion;
each of the normal side surfaces has a connection portion which is connected to the mounting board; and
in at least one of the normal side surfaces, a total length of the connection portion in a horizontal direction is shorter than a length of the normal side surface in the horizontal direction.

3. A shield case which is used for covering an elemental device arranged on a predetermined region of a mounting board when the shield case is mounted on the mounting board having the predetermined region, wherein:
the shield case has a top surface portion and a sidewall portion extending downward from the top surface portion;
the shield case is mounted on the mounting board when used so that the sidewall portion is located on a boundary line between an inside of the predetermined region and an outside of the predetermined region when viewed from above;
the sidewall portion has a full wall portion reaching a lower end of the shield case and a half wall portion extending downward from the top surface portion by a predetermined size;
the half wall portion does not reach the lower end of the shield case, so that an opening portion is formed under the half wall portion so as to communicate an inside of the shield case with an outside of the shield case; and
the opening portion allows the elemental device to be mounted on the mounting board so that the elemental device straddles the boundary line between the inside of the predetermined region of the mounting board and the outside of the predetermined region of the mounting board.
